Europäisches Patentamt

European Patent Office

Office européen des brevets

(19)

(11) Numéro de publication: **0 233 427**
**B1**

(12) **FASCICULE DE BREVET EUROPEEN**

(45) Date de publication du fascicule du brevet:
**11.04.90**

(21) Numéro de dépôt: **86402881.6**

(22) Date de dépôt: **19.12.86**

(51) Int. Cl.⁴: **E04H 9/04,** E06B 5/12,
E06B 5/18, E04B 1/98, H05K 9/00

(54) **Abri technique à parois composites blindées.**

(30) Priorité: **27.12.85 FR 8519328**

(43) Date de publication de la demande:
**26.08.87 Bulletin 87/35**

(45) Mention de la délivrance du brevet:
**11.04.90 Bulletin 90/15**

(84) Etats contractants désignés:
**AT BE CH DE ES GB GR IT LI LU NL SE**

(56) Documents cités:
**EP-A- 0 009 654
CH-A- 569 205
DE-A- 2 601 277
DE-B- 1 112 152
FR-A- 2 543 602
GB-A- 488 969
US-A- 3 093 098
US-A- 3 650 520**

(73) Titulaire: **LHOTELLIER BOURGOGNE INDUSTRIES,
13, avenue du Bois Genelard,
F-71420 Perrecy-les-Forges(FR)**

(72) Inventeur: **Frangolacci, Roger, Le Mas de Collines Voie
Julia, F-06110 Le Cannet(FR)**

(74) Mandataire: **Martinet & Lapoux, 62, rue des Mathurins,
F-75008 Paris(FR)**

## Description

La présente invention concerne un abri technique comprenant des parois encadrées par des éléments d'une ossature métallique. Cet abri peut être transportable, en particulier aérotransportable, et est destiné à protéger efficacement des équipements et des usagers non seulement contre de quelconques intempéries mais également contre des interférences électromagnétiques et radioélectriques.

Un tel abri est divulgué dans le brevet français FR-B 2 543 602. Les parois de cet abri sont constituées chacune par un simple panneau sandwich ayant une âme en bois léger, tel que balsa, ou en mousse de polyuréthane, et des peaux superficielles, telles que des feuilles d'aluminium collées sur les faces de l'âme. Les parois sont rigidement fixées à l'ossature de l'abri et forment ainsi une double cage de Faraday. Les peaux métalliques des parois sont reliées aux traverses, montants et longerons de l'ossature par soudure continue afin de réaliser une bonne continuité électrique et ainsi un blindage contre tout rayonnement d'ondes électromagnétiques et radioélectriques dans une plage d'un herz à une dizaine de gigahertz.

Cependant un tel abri n'assure pas une protection effiace contre l'un des effets principaux résultant d'une violente explosion, notamment nucléaire, se traduisant par une puissante onde de choc.

L'invention vise donc à fournir un abri technique offrant une protection efficace contre l'effet mécanique dû à la déflagration d'une explosion nucléaire par exemple, c'est-à-dire permettant d'absorber dans une large mesure, le souffle, l'onde de choc et les ondes acoustiques émanant d'une telle explosion.

A cette fin, un abri selon l'invention est tel que défini dans la revendication 1.

La structure composite d'une telle paroi peut être également celle d'une porte de l'abri. La face métallique de la paroi peut être reliée par soudure en continu à l'ossature.

Les premiers moyens d'amortissement qui sont logés dans le lame d'air entre les panneaux intérieur et extérieur de la paroi, amortissent ainsi tout déplacement du panneau extérieur dû au souffle d'une explosion et évitent ainsi de violentes vibrations de l'abri. La lame d'air joue le rôle d'un «piège acoustique» et contribue à atténuer des ondes acoustiques générées par l'explosion. Les seconds moyens d'amortissement de préférence logés entre des bords de la face externe du panneau extérieur et des bords ou couvre-joints du cadre de l'ossature entourant la paroi assurent principalement l'étanchéité même lorsque le panneau extérieur se déplace vers l'intérieur, en comprimant les premiers moyens d'amortissement.

Les premiers moyens d'amortissement peuvent être sous la forme de rubans en caoutchouc de préférence tubulaires, d'anneaux ou de ressorts ou câbles hélicoïdaux assujetis aux panneaux intérieur et extérieur, ou bien encore de ressorts à boudin ou d'ensembles de rondelles Belleville à axes perpendiculaires aux panneaux. Les seconds moyens d'amortissement sont constitués de préférence par un cadre de ruban plat en caoutchouc.

Par ailleurs, comme on le verra dans la suite, le panneau extérieur est un panneau de blindage contre des projectiles de toute nature, tandis que le panneau intérieur assure principalement une protection contre des ondes électromagnétiques et radioélectriques. De préférence, le panneau extérieur d'une paroi est en matière synthétique de préférence armée de fibres de verre, carbone ou analogue ou d'un métal de préférence déployé, ou est composé d'une première plaque en matière synthétique, de préférence du genre stratifié à couches de fibres du genre KEVLAR, entourée d'une enveloppe de protection de preférence en PVC, et d'une seconde plaque de préférence en nid d'abeille en aluminium ou en papier phénolique, ou d'une seconde plaque du genre panneau sanwich. Les première et seconde plaques sont de préférence orientées respectivement vers l'extérieur et l'intérieur de l'abri.

D'autres avantages et caractéristiques de l'invention apparaîtront plus clairement à la lecture de la description suivante de plusieurs réalisations préférées de l'invention en référence aux dessins annexés dans lesquels :

- la Fig.1 est une vue schématique en coupe horizontale d'un abri selon l'invention, comprenant une simple porte et une double porte dans deux côtés parallèles :
- la Fig.2 est une vue schématique en coupe verticale de l'abri ;
- les Figs.3A, 3B et 3C forment une vue détaillée en coupe horizontale du côté de l'abri incluant la simple porte ; et
- les Figs.4A et 4B montrent une vue détaillée en coupe horizontale de l'embrasure d'une double porte de l'abri.

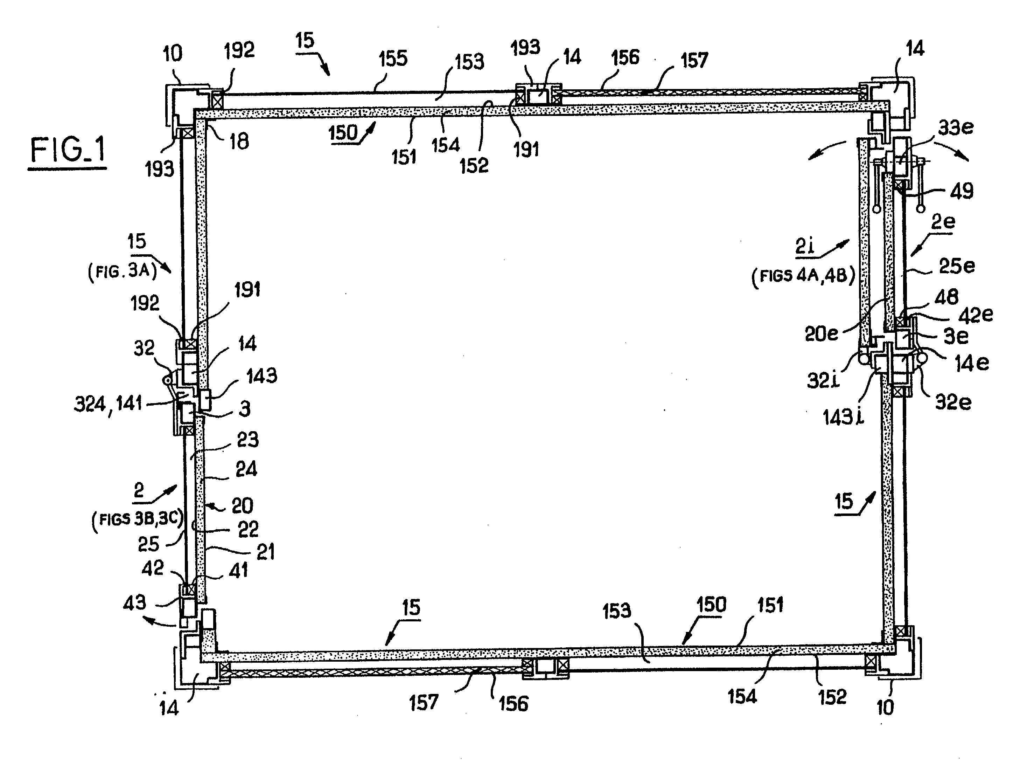

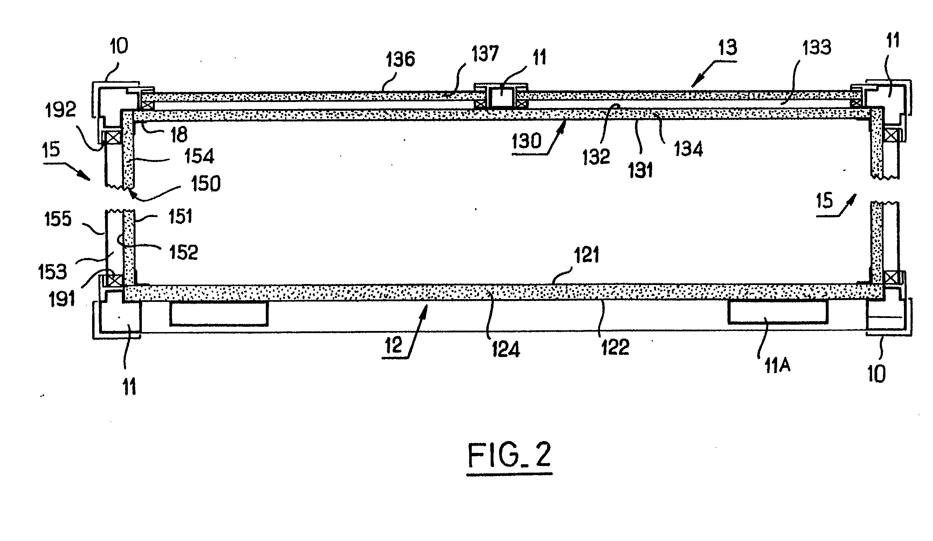

Comme montré aux Figs.1 et 2, un abri technique offre une ossature parallèlépipédique monobloc rigide en alliage léger composé essentiellement d'aluminium. L'ossature est constituée de profilés tubulaires reliés enter eux par huit coins ISO 10. Des profilés sont des longerons et traverses 11 pour encadrer respectivement un plancher 12 et un plafond 13 en vue de former un soubassement et un pavillon de l'abri, et d'autres profilés sont des montants 14 pour encadrer evec des traverses et longerons respectifs des côtés verticaux 15 de l'abri. En fonction des dimensions de l'abri, par exemple des côtés peuvent être partagés en plusieurs parois juxtaposées par des montants intermédiaires 14, notamment lorsqu'une porte d'accès est prévue, et le plafond peut comprendre des traverses et/ou longerons intermédiaires 11.

Accessoirement, l'abri est équipé en soubassement, de deux traverses profilées à section rectangulaires 11A destinées au passage de fourche d'un chariot-élévateur, de deux longerons profilés à section en oméga renversé (non représenté) servant de patins pour le chargement de l'abri sur un plan tel que celui d'une soute d'avion, et de douilles, écrous prisonniers ou analogues à la périphérie des longerons et traverses encadrant le plancher pour permettre notamment un arrimage de l'abri dans un véhicule transporteur, tel qu'avion. Dans les montants 14, entre les coins, peuvent être prévues des cavités en forme de poignée constituant des chapes d'arrimage pour accrocher une élingue et ainsi hisser l'abri par un appareil de levage.

A titre d'exemple auquel on se référa dans la suite en ce qui concerne des caractéristiques numériques, l'abri a une longueur hors-tout de 2,99 m, une largeur de 2,44 m et une hauteur de 2,33 m.

Le plancher 12 est constitué par un panneau rectangulaire du type sandwich formé par une âme en mousse de polyuréthane 124 ayant une épaisseur de 57 mm et une densité de 150 kg/m³, et par deux peaux en aluminium 121 et 122 ayant une épaisseur de 2,5 mm, collées sur les faces de l'âme. Lorsque le plancher 12 n'est pas démontable, celui-ci est soudé en continu aux quatre coins ISO et aux longerons et traverses du soubassement, ce qui assure une parfaite étanchéité pour la continuité électrique. Dans le cas d'un plancher vissé démontable, des tresses métalliques et des rubans en caoutchouc encadrés par les tresses sont encastrés dans des rainures sur tout le pourtour du soubassement entre le plancher d'une part et les coins, traverses et longerons d'autre part, afin d'assurer une parfaite continuité électrique et un blindage, ainsi qu'une étanchéite entre ossature et plancher.

Ainsi l'ossature et le plancher ont d'une manière générale des structures analogues à celles décrites dans le FR-B-2 543 602, et on se reportera à ce document pour de plus amples détails.

On décrit maintenant en détail des caractéristiques de l'abri propres à l'invention tout d'abord en ce qui concerne la structure composite de parois de l'abri, côtés 15 et plafond 13, puis en ce qui concerne celle d'une simple porte puis d'une double porte.

Selon l'invention, chaque paroi est composée d'un panneau extérieur, d'un panneau intérieur et d'une lame d'air emprisonnée entre ces deux panneaux parallèles.

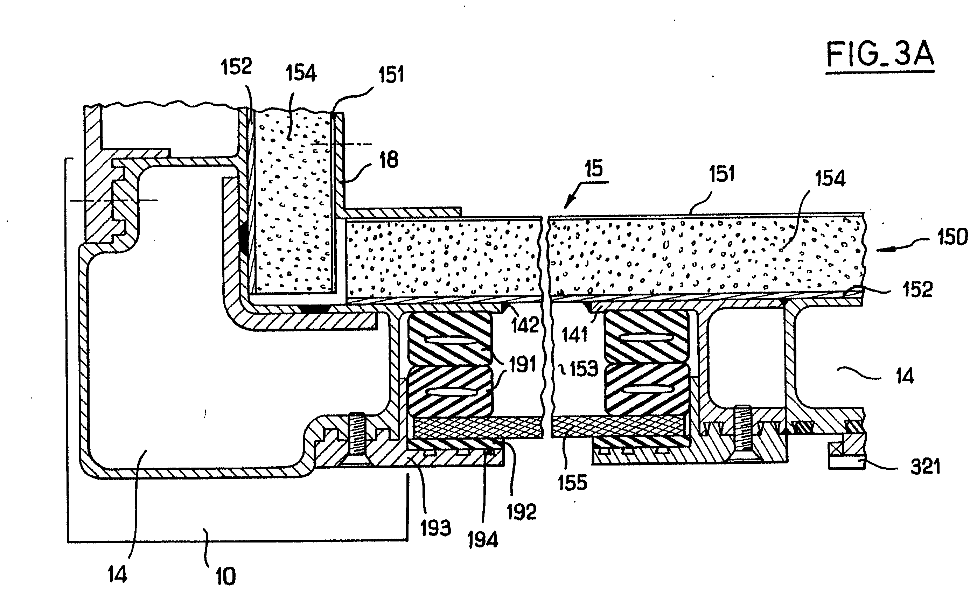

Un panneau intérieur est un panneau du type sandwich 130, 150 comprenant deux peaux en aluminium, l'une intérieure 131, 151 ayant une épaisseur de 1 mm et l'autre extérieure 132, 152 ayant une épaisseur de 2,5 mm et délimitant la lame d'air 133, 153, et une couche de mousse de polyuréthane 134, 154 entre-collée aux deux peaux, ayant une épaisseur de 36 mm et une densité de 100 kg/m³. Comme montré en détail à la Fig.3A, la peau extérieure 132, 152 d'un panneau intérieur est en général appliquée contre un côté de l'encoignure interne de chacun des montants, longerons ou traverses respectifs encadrant le panneau intérieur, et/ou contre un tel côté prolongé par une nervure d'appui 141, 111, et est fixée à ces éléments d'ossature par des cordons de soudure en continu tel que 142. Ces cordons de soudure assurent ainsi une étanchéité parfaite entre l'intérieur de l'abri et l'extérieur de l'abri au niveau des lames d'air. En outre, les peaux intérieures 131, 151 des panneaux intérieurs des parois et du plafond et la peau intérieure du plancher sont reliées mécaniquement et électriquement par des profilés d'habillage internes 18 en aluminium soudés, de sorte que les panneaux intérieurs 130, 150 et le plancher 12 forment une double cage de Faraday.

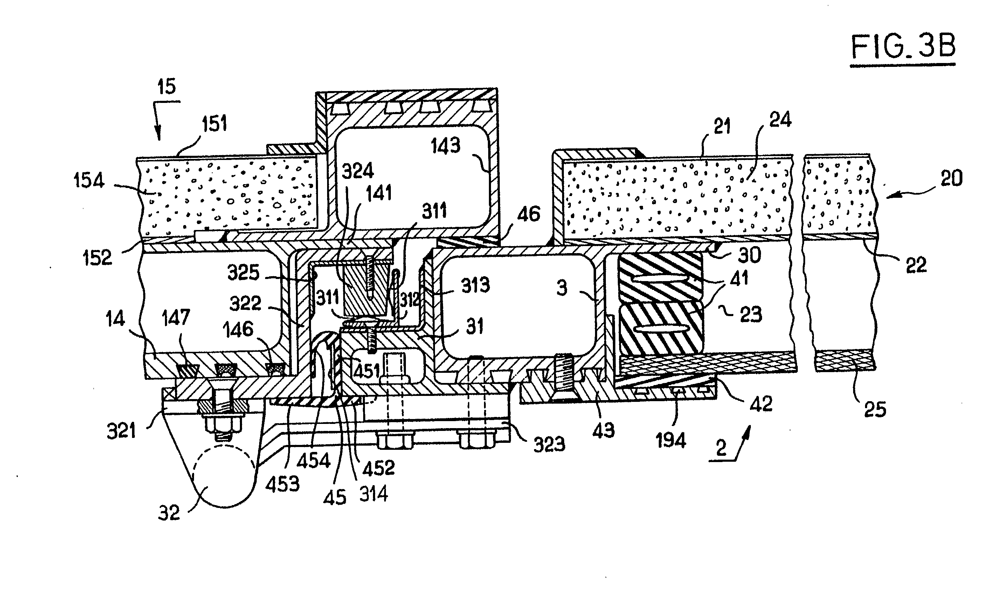

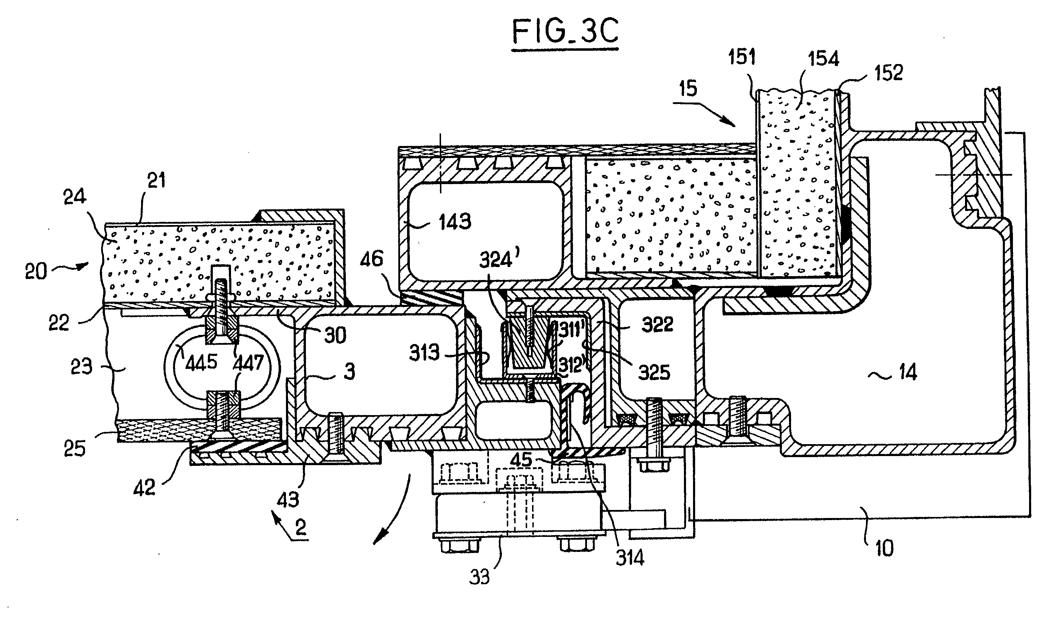

Un panneau extérieur de blindage d'une paroi 13, 15, ou d'un vantail de porte extérieure 3, 3e décrit plus loin, est, selon une première variante montrée en haut et à gauche et en bas et à droite dans la Fig. 1, latéralement dans la Fig.2, et en détail dans la Fig.3, une plaque stratifiée 155 en matière synthétique, telle que résine époxy, armée de fibres de verre, de carbone ou analogue, ou d'éléments métalliques, tels que plaques de métal déployé, ayant une épaisseur de 10 à 14 mm. Selon une seconde variante montrée en haut et à droite et en bas et à gauche dans la Fig.1, un panneau extérieur d'une paroi 13 est composé d'une plaque externe 156 constituée par 23 couches ou plis de fibres synthétiques pour former un stratifié en KEVLAR, autour duquel est soudée une enveloppe de protection toilée en PVC ayant des caractéristiques NBC (Neutron-biologique-Chimique), et d'une plaque intérieure 157 en nid d'abeille en aluminium ou en papier phénolique du type Nomex recouverte par deux peaux d'aluminium ou de verre epoxy. Les plaques 156 et 157 sont collées. Les plaques 156 et 157, ont respectivement des épaisseurs de 4 mm et 20 mm. Selon une troisième variante de préférence utilisable pour le plafond 13, comme montré à la Fig.2, un panneau extérieur est composé d'une plaque intérieure du type sandwich 137, analogue au panneau intérieur 130, 150, comprenant une couche en mousse de polyuréthane collée entre une peau intérieure d'épaisseur 1 mm et une peau extérieure d'épaisseur 2,5 mm en aluminium et d'une plaque extérieure 136 identique à la plaque précitée 156.

Les panneaux extérieurs confèrent une excellente résistance en balistique, c'est-à-dire contre tout projectible frappant violemment l'abri.

La résistance de l'abri à des souffles d'air provoqués par des explosions est assurée principalement par des liaisons élastiques entre le panneau intérieur et le panneau extérieur dans chaque paroi, conjointement à la lame d'air 133, 153 qui atténue également toute onde acoustique provoquée par une explosion, en découplant mécaniquement les panneaux intérieur et extérieur.

Selon la réalisation montrée en détail à la Fig.3A, la liaison élastique est réalisée par des premiers joints en élastomère ou caoutchouc, ou des paires de joints en élastomère ou caoutchouc accolés 191, et des seconds joints en caoutchouc 192 formant des doubles cadres souples entourés par les montants, traverses ou longerons correspondants 14, 11. Les joints 191 sont emprisonnés entre les nervures 112, 141 auxquelles sont soudées les peaux extérieures 132, 152 des panneaux intérieurs 130, 150, ou sont emprisonnés entre ces dernières peaux et les faces intérieures des panneaux extérieurs 137+138, 155, 156+157. Chacun des joints 192 est plat et enserré entre la face externe d'un panneau extérieur et une première aile d'une couvre-joint en aluminium, profilé en T, dit té de pincement 193, du genre décrit dans le FR-B-2 543 602. Une seconde aile du té est fixée au moyen de vis dans une entaille à rainures du montant, longeron ou traverse correspondant, orientée vers l'extérieur. Contre un côté latéral du montant, longeron ou traverse est plaquée une jambe du té contre laquelle est appuyé le chant d'au moins l'un des joints 191 et du joint plat 192. Dans la première aile du té sont pratiquées des rainures dans lesquelles peuvent être encastrés des joints en caoutchouc 194, tel que néoprène, appliqués contre le joint plat 192 afin d'améliorer l'étanchéité.

Comme montré à la Fig.3A, les joints 191 sont des rubans d'élastomère ou de caoutchouc tubulaires à section rectangulaire, et peuvent donc subir un relatif écrasement afin d'amortir, conjointement à la lame d'air contiguë 153, toute poussée soudaine du panneau extérieur 155 vers l'intérieur de l'abri. Dans ce cas, les joints 191 sont compressés et les joints 192 sont dilatés, tout en assurant une étanchéite suffisante grâce à la présence des petits joints au néoprène 194 et au contact des jambes des tés 193 avec des chants latéraux des joints 191 et 192. Ainsi les panneaux extérieurs sont montés "flottants" et fixés d'une manière étanche et interchangeable.

En référence aux Figs.3B et 3C, une simple porte de l'abri, ici à poussée à droite vers l'extérieur, comporte un vantail 2 ayant une structure composite analogue à celle d'une paroi 13, 15, c'est-à-dire ayant un panneau intérieur 20, une lame d'air 23, et un panneau extérieur 25. Selon la réalisation illustrée de l'embrasure de la porte, le panneau intérieur 20 est un panneau sandwich à âme 24 en mousse de polyuréthane ayant une épaisseur de 36 mm et une densité de 100 kg/m³ et des peaux intérieure et extérieure 21 et 22 en aluminium ayant une épaisseur de 2,5 mm. Le panneau extérieur 25 est, selon la réalisation illustrée, un panneau stratifié en matière synthétique armée ayant une épaisseur de 14 mm. La lame d'air 23 a une épaisseur de 50 mm. Les panneaux 20 et 25 sont assemblés dans un précadre monobloc à deux montants et deux traverses 3 à section rectangulaire et nervures d'appui 30 d'une manière analogue à l'assemblage des panneaux 130 et 135, 150 et 155 entre des montants, longerons et traverses de l'ossature.

Différentes variantes de premiers moyens d'amortissement au souffle d'explosion sont décrites ci-après. Ces différentes variantes sont intégrables aussi bien dans une porte que dans une paroi de l'abri.

Selon une première variante montrée dans la Fig.3B, des premiers moyens d'amortissement au souffle d'explosion sont deux rubans tubulaires 41 accolés entre les nervures 30 et le panneau extérieur 25, comme le montage des rubans 191. Selon une seconde variante montrée à la Fig.3C, des moyens d'amortissement au souffle sont sous la forme d'anneaux ovales en acier 445 logés dans la lame d'air 23 à la périphérie de celle-ci et alignés verticalement et horizontalement le long du pourtour intérieur du précadre 3 par des fixations diamétralement opposées 447 assujetties par vis au panneau extérieur 25 d'une part, et aux nervures intérieures de précadre 30 et au panneau intérieur 20. Les fixations 447 sont des paires de petites mâchoires ou demi-colliers enserrant des portions opposées des anneaux 445. Selon d'autres variantes, les anneaux 445 peuvent être remplacés par des ressorts ou câbles hélicoïdaux dont deux ont des axes verticaux parallèles aux montants et dont deux autres ont des axes horizontaux parallèles aux traverses, ayant des spires maintenues par des attaches analogues aux fixations 447, ou peuvent être remplacés par d'autres moyens élastiques métalliques, tels que des petits ressorts à boudins ou des ensembles de plusieurs paires empilées de rondelles Belleville tête-bêche, enfilés autour d'axes ou broches fixés perpendiculairement aux panneaux 20 et 25 et traversant la lame d'air 23.

Les seconds moyens d'amortissement comprennent un cadre en ruban de caoutchouc plat 42 analogue au ruban 192, inserré entre la face externe du panneau extérieur 25 et une première aile d'un couvre-joint externe profilé en té 43, analogue au couvre-joint 193 pour paroi. Le couvre-joint 43 et la face externe et des chants du panneau intérieur 20 sont fixés de part et d'autre du précadre du vantail 3, respectivement par vis et soudures. Des tresses métalliques de blindage et des petits rubans d'étanchéité en caoutchouc peuvent être prévus dans des rainures aux jonctions du couvre-joint 43 et du précadre 3, et des joints d'étanchéité au néoprène peuvent être prévus aux jonctions du couvre-joint 43 et du joint plat 42.

La porte simple est une porte à couteaux et à charnières extérieures 32 alignées le long d'un montant vertical 14 du bâti de porte intégré à l'ossature. La porte offre une feuillure et une contre-feuillure en paume droite non-jointive afin de loger des moyens de contact électrique sous la forme de couteaux et butées coopérantes, comme on le verra dans la suite. Des ferrures fixes à embase 321 des charnières 32 sont boulonnées contre une aile externe verticale d'un cadre profilé mince en aluminium 322 en forme de Z droit constituant la feuillure, soudé au bâti de porte. Des ferrures pivotantes telles que barres en T 323 des charnières 32 sont boulonnées au précadre 3 et à l'âme à section rectangulaire d'un cadre de chant 31 du vantail en aluminium constituant la contre-feuillure et avant une cornière soudée au précadre 3. Comme on le voit dans les Figs.3B et 3C, l'âme du cadre de contre-feuillure 31 est située vers l'extérieur, sensiblement à mi-épaisseur du précadre 3, et une aile interne du profilé de feuillure 322 est plaquée contre les ailes 111, 141 des deux traverses 11 et des deux montants 14 du bâti de porte, de sorte qu'en position fermée de la porte est créé un conduit entourant le précadre 3 situé entre feuillure et contre-feuillure, ayant une largeur sensiblement inférieur à la moitié de l'épaisseur du précadre 3, pour y loger des contacts à couteaux et butées.

Le long du montant de bâti 14, du côté des charnières 32, comme montré à la Fig.3B, et le long des traverses horizontales du bâti dormant, les butées sont constituées par un précadre à section en trapèze rectangle 324 fixé par vis contre l'aile interne du profilé de feuillure 322 par l'intermédiaire d'une cornière mince 325 soudée au profilé 322. Les couteaux sont des lamelles flexibles conductrices électriquement 311 enclipsées sur des ailes d'une petite cornière 312 fixée par des vis au cadre de contre-feuillure 31 par l'intermédiaire d'une cornière mince 313 soudée au cadre 31. Porte fermée, comme illustrée à la Fig.3B, la cornière 325 est diagonalement opposée aux cornières 312 et 313, et les lamelles 311 sont pressées respectivement contre un côté incliné et une petite base de la butée 324.

Du côté du chant vertical du vantail opposé aux charnières, comme montré à la Fig.3C, des moyens de contact électrique analogues aux précédents, et une serrure de sûreté à trois points de verrouillage 33 sont prévues. Cependant, la butée est une barre verticale à section horizontale en trapèze isocèle 324', et deux lamelles flexibles conductrices électriquement 311' sont enclipsées sur des ailes parallèles d'un profilé mince en U 312' qui vient encadrer la butée 324' lors de la fermeture de la porte. Les lamelles 311' glissent le long des côtés inclinés de la butée 312' et sont aplaties contre ceux-ci.

De préférence, la cornière à lamelle 312, le profilé en U à lamelles 312', et les butées 324 et 324' sont en un alliage ayant une bonne conductibilité électrique, et une bonne résistance à la corrosion, tout en offrant une certaine ductilité du fait des sollicitations nombreuses à l'ouverture et la fermeture de la porte. Selon une réalisation préférée, les pièces précitées 312, 312', 324 et 324' sont en laiton, et les lamelles 311 et 311' sont en un alliage à base de bronze et de beryllium. Les lamelles assurent une excellente continuité électrique entre le vantail 2 et les parois de l'ossature lorsque la porte est fermée, afin de constituer une cage de Faraday. Les cornières intermédiaires 325 et 313 sont bimétalliques, en aluminium et cuivre, afin d'éviter une formation de couples galvaniques pouvant détériorer les pièces en contact. En outre des soudages sont réalisés sur le cadre en aluminium 31, non pas directement avec les pièces en laiton 312 et 312' supportant les lamelles, mais avec les cornières 313 et 313', ce qui assure un excellent contact mécanique et électrique entre lamelle et cadre de contre-feuillure 31.

Porte fermée, le conduit entre feuillure et contre-feuillure, contenant les contacts à butées et couteaux, est maintenu étanche principalement grâce à un joint extérieur en caoutchouc 45 profilé en T, entourant le cadre de contre-feuillure 31. Une jambe 451 du joint en T 45 est maintenue fermement entre des chants du cadre 31 et des armatures minces 314 soudées à ces chants. Deux ailes externes 452 et 453 du joint 45 s'appuient hermétiquement contre des bords externes du cadre 31 et de l'aile externe du profilé en Z de feuillure 322. Les ailes 452 et 453 du côté des charnières 32 contribuent grâce à leur élasticité, comme un ferme-porte, à rabattre la porte en position fermée. La jambe 451 est terminée par une lèvre 454 coudée à 180° fléchie en permanence contre l'âme plate intermédiaire du profilé 322. On notera également que du côté extérieur peuvent être prévues des tresses métalliques de blindage 146 et des petits rubans d'étanchéité en caoutchouc 147 encastrés entre des rainures et languettes du bâti 11-14 de la porte et l'aile externe du profilé de feuillure 322.

Vers l'intérieur, sur un côté du précadre 3 du vantail 2, au niveau d'une encoche entre le précadre 3 et le panneau intérieur 20, est collé un cadre de ruban plat en caoutchouc 46. Le ruban 46 est destiné à être appliqué contre des côtés externes de contre-montants et contre-traverses 143, 113 du bâti dormant, diagonalement opposés aux montants et traverses 14, 11 du bâti, conformés d'une manière analogue à ces derniers et longeant les panneaux intérieurs des parois entourant la porte. Le joint 46 assure une étanchéité de l'intérieur de l'abri par rapport au conduit contenant les butées 324, 324' et lamelles 311, 311' entre feuillures et contre-feuillures lorsque la porte est fermée, et contribue également à amortir toute poussée du vantail créée par souffle d'explosion.

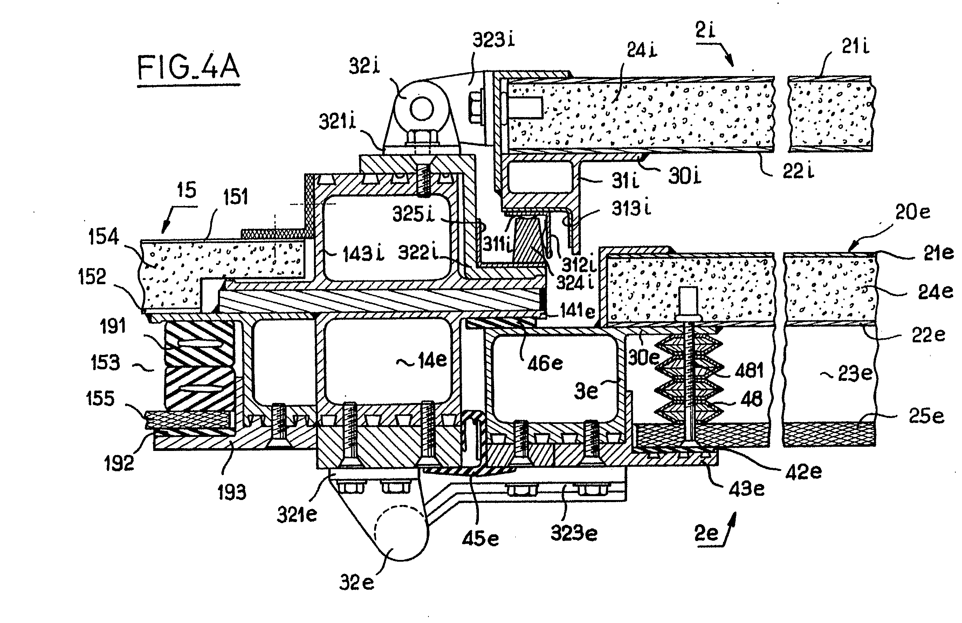

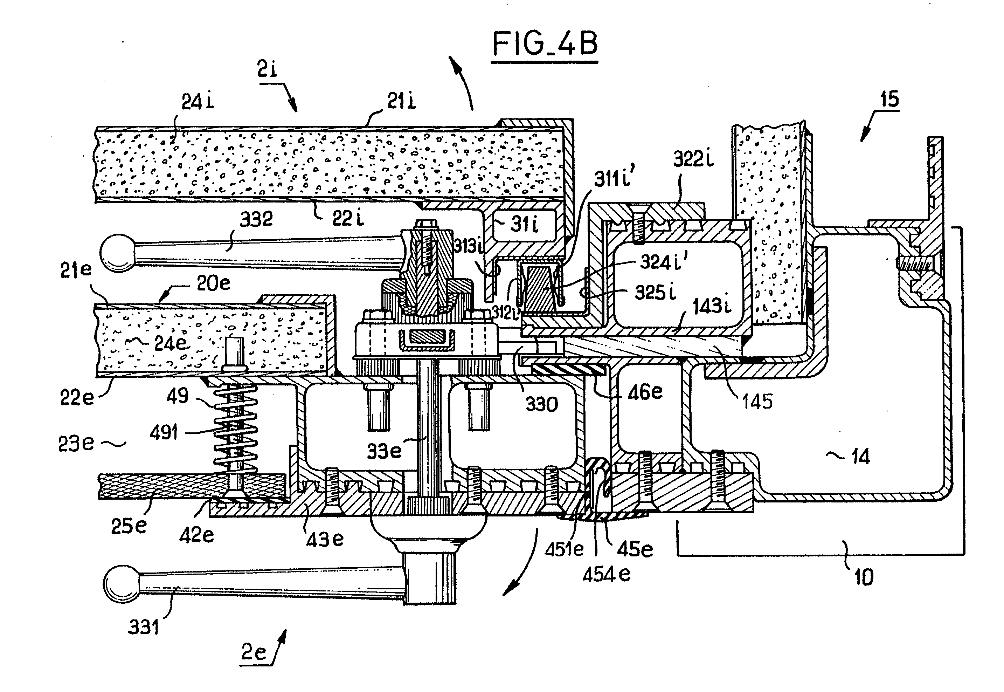

En référence maintenant aux Fig.s 4A et 4B, une double porte de l'abri comprend une porte extérieure à vantail 2e, ici ouverte en poussant à droite vers l'extérieur, et une porte intérieure à vantail 2i, ici ouverte en poussant à gauche vers l'intérieur ; dans ce cas, des charnières 32e et 32i des portes extérieure et intérieure sont de part et d'autre d'un double montant de bâti de porte. Selon d'autres variantes, les deux portes extérieure et intérieure sont ouvertes en poussant à droite ou à gauche, et les charnières de ces deux portes sont fixées respectivement à deux montants de part et d'autre des vantaux de porte. Dans les Figs. 4A et 4B des pièces de la double porte ayant des fonctions analogues à celles de pièces de la simple porte montrée aux Figs. 3B et 3C sont répérées par des mêmes numéros de référence, aux indices e et i près, respectivement.

La porte extérieure assure la résistance au souffle et en balistique et présente une structure et un montage analogue à la simple porte à vantail 2, à l'exception qu'elle ne possède plus de contacts électriques à hautée et coteaux, ceux-ci étant reportés dans la porte intérieure. Les montants et traverses 14e du bâti de la porte extérieure ne comporte plus de profilé de feuillure 322, et le vantail 3e ne comporte plus de cadre de contre-feuillure 31. La feuillure et la contre-feuillure sont simplement en équerre et sont formées respectivement par les encoignures des montants et traverses 14e au niveau de leurs nervures internes 141e et par des coins de précadre 3e du vantail 2e sensiblement complémentaires des encoignures. La largeur de l'interstice entre feuillure et contre feuillure est obturée, côté extérieur, par un joint 45e en caoutchouc profilé en T et à jambe 451e à lèvre repliée 454e, analogue au joint 45, et côté intérieur, par un joint plat 46e analogue au joint 46, les joints 45e et 46e étant fixés au précadre 3e.

La structure composite du vantail 2e est analogue à celle du vantail 2, et est composée d'un panneau sandwich intérieur 20e à âme 24e en mousse de polyuréthane et à peaux en aluminium 21e et 22e, d'une lame d'air 23e, et d'un panneau extérieur "flottant" 25e. Les premiers moyens d'amortissement inclus dans la lame d'air 23e entre les panneaux 20e et 25e sont du type de ceux déjà décrits. Selon la réalisation illustrée à la Fig.4A, les moyens d'amortissement sont des ensembles de plusieurs paires empilées de rondelles Belleville tête-béche 48, enfilés autour de broches 481 vissées perpendiculairement aux panneaux 20e et 25e et traversant la lame d'air 23e. Selon la réalisation illustrée à la Fig.4B, les moyens d'amortissement sont des petits ressorts à boudin 49 guidés autour d'axes 491 vissés perpendiculairement aux panneaux 20e et 25e et traversant la lame d'air 23e. La face extérieure du panneau 25e est plaquée contre une aile d'un couvre-joint en té 43e ayant une autre aile fixée par vis au précadre 3e, par l'intermédiaire d'un joint plat 42e.

Par ailleurs, la porte extérieure comporte des charnières 32e à ferrure fixe 321e fixée au montant correspondant 14e, et à ferrure mobile 323e fixée au précadre de vantail 3e, ainsi qu'une serrure de sûreté 33e à trois points de verrouillage 330 ayant une bequille extérieure 331 et une béquille intérieure 332 accessible entre le panneau intérieur 20e le vantail intérieur 2i.

La porte intérieure 2i est déportée vers l'intérieur derrière la porte extérieure 3e. Elle est destinée à atténuer des interférences électromagnétiques et radioélectriques de toutes sortes, et à assurer la continuité électrique avec les panneaux intérieurs des parois de l'abri formant une double cage de Faraday. Ainsi, le vantail 2i possède un unique panneau sandwich à âme en mousse de polyuréthane 24i et deux peaux en aluminium 21i et 22i, et en position fermé, est relié mécaniquement et électriquement par des contacts à butée 324i, 324i' et à lamelles flexibles 311i, 311i'. Le bâti dormant de la porte intérieure est constituée par deux contre-montants et deux contre-traverses 143i soudés contre des faces intérieures des montants et traverses 14e du bâti dormant de la porte extérieure par l'intermédiaire d'entretoises 145. Sur l'un des contre-montants 143i, derrière les charnières extérieures 32e, sont fixées par vis, des ferrures fixes 321i de charnières intérieures 32i ayant des ferrures mobiles 322i à embases fixées par vis à un chant vertical du vantail 2i.

Les contacts à butées et lamelles de la porte intérieure sont du même type que celles de la simple porte montrée aux Figs.3B et 3C et déduites de celles-ci par symétrie par rapport à un plan vertical sensiblement au niveau des lames d'air 153 des parois contiguës à la double porte. Ainsi, d'une part, sur les contre-montants et contre-traverses 143i est soudé un profilé de feuillure 322i en aluminium conformé en Z supportant sur une aile parallèle aux parois contiguës, des butées trapézoïdale en laiton 324i, 324i' par l'intermédiaire de cornière mince bimétallique 325i, et d'autre part sur un cadre de contre-feuillure en aluminium 31i à âme rectangulaire et cornière soudé contre la peau 22i, sont soudées des cornières bimétalliques verticales et horizontales 313i supportant des cornières 312i et un profilé vertical en U 312i' en laiton dans les ailes desquels sont enclipsées des lamelles flexibles 311i, et 311i' coopérant avec les butées 324i et 324i'.

Bien qu'un abri parallélipipédique soit décrit ci-dessus, l'invention concerne également des abris extensibles, de forme générale polyédrique, qui peuvent être réunis en des abris intercommunicant entre eux. Plusieurs accès peuvent être prévus suivant le montage des simple et double portes décrites ci-dessus. Tous ces abris sont conçus pour être transportables comme des containers.

En outre, les caractéristiques de structure des parois et des portes selon l'invention sont également utilisables à tout abri, habitacle, cabine fixe, ou transportable, ou intégré à un véhicule terrestre, aérien ou maritime. Le terme abri mentionné dans l'objet de la demande de brevet défini ci-après doit donc être compris selon un sens large.

## Revendications

1. Abri comprenant des parois (15) encadrées par des éléments (11, 14) d'une ossature métallique, au moins une paroi (15) comprenant un panneau (150) ayant au moins une face métallique (151 ; 152) reliée électriquement à des éléments de l'ossature (11, 14) encadrant la paroi, caractérisé en ce que ledit panneau est un panneau intérieur (150) et ladite paroi (15) comprend en outre un panneau extérieur de blindage (155 ; 156, 157), une lame d'air (153) entre les panneaux intérieur et extérieur, et des premiers et seconds moyens d'amortissement (191, 192) pour maintenir flottant le panneau extérieur entre le panneau intérieur et les éléments d'ossature (11, 14).

2. Abri conforme à la revendication 1, caractérisé en ce que le panneau intérieur (150) comprend deux faces métalliques (151, 152), de préférence en aluminium, reliées électriquement en parallèle à des éléments d'ossature (11, 14).

3. Abri conforme à la revendication 1 ou 2, caractérisé en ce que le panneau intérieur (150) est du type sandwich, à âme (154) de préférence en mousse de polyuréthane.

4. Abri conforme à l'une quelconque des revendications 1 à 3, caractérisé en ce que le panneau extérieur (154) est en matière synthétique de préférence armée de fibres de verre, carbone ou analogue ou d'éléments métalliques, tels que plaques en métal déployé.

5. Abri conforme à l'une quelconque des revendications 1 à 3, caractérisé en ce que le panneau extérieur est composé d'une première plaque en matière synthétique (156), de préférence stratifiée à couches de fibres du genre KEVLAR® , entourée d'une enveloppe de protection de préférence en PVC, et d'une seconde plaque (157) de préférence en nid d'abeille en aluminium ou en papier phénolique, les première et seconde plaques étant de préférence orientées respectivement vers l'extérieur et l'intérieur de l'abri.

6. Abri conforme à l'une quelconque des revendications 1 à 3, caractérisé en ce que le panneau extérieur est composé de préférence lorsque la paroi (13) est une partie de plafond de l'abri, d'une première plaque en matière synthétique (136), de préférence stratifiée à couches de fibres du genre KEVLAR, entourée d'une enveloppe de protection de préférence en PVC, et d'une seconde plaque (137) du genre panneau sandwich composé d'une âme de préférence en mousse de polyuréthane, ayant des faces métallisées de préférence en aluminium, les première et seconde plaques étant de préférence orientées respectivement vers l'extérieur et l'intérieur de l'abri.

7. Abri conforme à l'une quelconque des revendications 1 à 6, caractérisé en ce que les premiers moyens d'amortissement sont logés dans la lame d'air (153) entre les panneaux intérieur et extérieur et comprennent un joint en matière synthétique souple (191), constitué de préférence par un ou plusieurs rubans en caoutchouc accolés, de préférence tubulaires.

8. Abri conforme à l'une quelconque des revendications 1 à 6, caractérisé en ce que les premiers moyens d'amortissement logés dans la lame d'air (153) entre les panneaux intérieur et extérieur sont des anneaux (445) assujettis aux faces des panneaux intérieur et extérieur délimitant la lame d'air.

9. Abri conforme à l'une quelconque des revendications 1 à 6, caractérisé en ce que les premiers moyens d'amortissement logés dans la lame d'air (153) entre les panneaux intérieur et extérieur sont constitués par des ressorts ou câbles hélicoïdaux assujettis aux faces des panneaux intérieur et extérieur délimitant la lame d'air.

10. Abri conforme à l'une quelconque des revendications 1 à 6, caractérisé en ce que les premiers moyens d'amortissement logés dans la lame d'air (153) entre les panneaux intérieur et extérieur sont des ressorts à boudin (49) s'étendant perpediculairement aux panneaux intérieur et extérieur.

11. Abri conforme à l'une quelconque des revendications 1 à 6, caractérisé en ce que les premiers moyens d'amortissement logés dans la lame d'air (153) entre les panneaux intérieur et extérieur sont des ensembles de rondelles Belleville (48) enfilés autour de broches (481) perpendiculaires aux panneaux intérieur et extérieur.

12. Abri conforme à l'une quelconque des revendications 1 à 11, caractérisé en ce que les seconds moyens d'amortissement sont un joint en matière synthétique souple (192), tel que ruban plat en caouchouc.

13. Abri conforme à la revendication 12, caractérisé en ce que les seconds moyens d'amortissement (192) sont enserrés entre une face externe du panneau extérieur (155) et un couvre-joint démontable (193), de préférence à profil en té, fixable aux éléments d'ossature (11, 14) encadrant la paroi (15), de préférence par l'intermédiaire de joints d'étanchéité (147) et/ou de joints électriques (146).

14. Abri conforme à l'une quelconque des revendications 1 à 13, caractérisé en ce que ladite paroi (20, 23, 25) et les éléments (3) encadrant la paroi constituent un vantail (2) d'une porte de l'abri ayant un bâti formé par des montants et traverses (14, 11) de l'ossature.

15. Abri conforme à la revendication 14, caractérisé en ce que deux joints souples d'étanchéité (45, 46), de préférence fixés autour du vantail (2), obstruent un interstice entre feuillure (322) et contre-feuillure (31) de la porte lorsque celle-ci est fermée.

16. Abri conforme à la revendication 15, caractérisé en ce que l'un (45) des deux joints d'étanchéité à une section transversale en T ayant des ailes (452, 453) de préférence appliquée et applicable contre des bords de faces externes du vantail (2) et du bâti (14) respectivement, une jambe (451) assujettie à la contre-feuillure (31) du vantail (2), et une lèvre coudée (454) appliquée contre la feuillure (322) du bâti.

17. Abri conforme à l'une quelconque des revendications 14 à 16, caractérisé en ce qu'il comprend des moyens de contact électrique (324, 311) fixés pour partie à la feuillure (322) de la porte et pour partie à la contre feuillure (31) de la porte.

18. Abri conforme à l'une quelconque des revendications 14 à 16, caractérisé en ce qu'il comprend une porte intérieure (2i) logée derrière la porte précitée dite extérieure (2e), la porte intérieure (2i) ayant un vantail (21i, 22i, 24i) analogue à un panneau intérieur (150) de paroi (15) de l'abri et ayant un bâti formés par des montants et traverses (143i) de l'ossature.

19. Abri conforme à la revendication 18, caractérisé en ce qu'il comprend des moyens de contact électrique (324i, 311i) fixés pour partie à la feuillure (322i) de la porte intérieure et pour partie à la contre-feuillure (31i) de la porte intérieure.

20. Abri conforme à la revendication 17 ou 19, caractérisé en ce que les moyens de contact électrique comprennent une butée métallique (324 ; 324i) de préférence en laiton, fixée à la feuillure (322 ; 322i), et un support métallique (312, 312i), de préférence en laiton, fixé à la contre-feuillure (31 ; 31i) et supportant des lamelles flexibles de contact 311 ; 311i) propres à venir au contact de la butée (31, 31i) lorsque la porte (2, 2i) est fermée.

21. Abri conforme à la revendication 20, caractérisé en ce que la butée (324 ; 324i) et le support de lamelles (312 ; 312i) sont respectivement fixés à la feuillure (322 ; 322i) et à la contre-feuillure (31 ; 31i) par l'intermédiaire de pièces bimétalliques (325 ; 325i ; 312 ; 312i), de préférence en aluminium et cuivre.

**Patentansprüche**

1. Schutzraum, der Wände (15) umfaßt, die von Elementen (11, 14) eines metallischen Gerippes eingerahmt sind, wobei wenigstens eine Wand (15) eine Füllung (150) umfaßt, die wenigstens eine metallische Außenseite (151; 152) aufweist, die elektrisch mit den Elementen des Gerippes (11, 14), welche die Wand einrahmen, verbunden ist, dadurch gekennzeichnet, daß besagte Füllung eine innere Füllung (151) ist und daß besagte Wand (15) außerdem eine äußere Panzerungsfüllung (155; 156, 157), eine Luftschicht (153) zwischen der äußeren und der inneren Füllung und erste und zweite Dämpfungsmittel (191, 192) umfaßt, um die äußere Füllung schwingungsgedämpft zwischen der inneren Füllung und den Gerippeelementen (11, 14) zu halten.

2. Schutzraum nach Anspruch 1, dadurch gekennzeichnet, daß die innere Füllung (150) zwei metallische Außenseiten (151, 152), vorzugsweise aus Aluminium, umfaßt, die mit den Gerippeelementen (11, 14) elektrisch parallel verbunden sind.

3. Schutzraum nach Anspruch 1 oder 2, dadurch gekennzeichnet, daß die innere Füllung (150) sandwichartig aufgebaut ist, mit vorzugsweise Polyurehanschaum im Kern (154).

4. Schutzraum nach einem der Ansprüche 1 bis 3, dadurch gekennzeichnet, daß die äußere Füllung (155) aus Kunststoff ist, der vorzugsweise mit Fasern aus Glas, Kohlenstoff oder dgl. oder mit metallischen Elementen, wie etwa Platten aus Streckmetall, verstärkt ist.

5. Schutzraum nach einem der Ansprüche 1 bis 3, dadurch gekennzeichnet, daß die äußere Füllung aus einer ersten Platte aus Kunststoff (156), vorzugsweise als Laminat von Schichten aus Fasern der Gattung KEVLAR®, umgeben von einer Schutzhülle aus vorzugsweise PVC, und einer zweiten Platte (157), vorzugsweise aus wabenförmigem Aluminium oder Phenolpapier, zusammengesetzt ist, wobei die erste und die zweite Platte vorzugsweise zum Äußeren bzw. zum inneren des Schutzraums gerichtet sind.

6. Schutzraum nach einem der Ansprüche 1 bis 3, dadurch gekennzeichnet, daß die äußere Füllung, wenn die Wand (13) ein Teil der Decke des Schutzraums ist, vorzugsweise aus einer ersten Platte aus Kunststoff (136), vorzugsweise als Laminat von Schichten aus Fasern der Gattung KEVLAR, umgeben von einer Schutzhülle aus vorzugsweise PVC, und einer zweiten sandwichplattenartigen Platte (137), zusammengesetzt aus einem Kern aus vorzugsweise Polyurethanschaum, der metallisierte Außenseiten aus vorzugsweise Aluminium aufweist, zusammengesetzt ist, wobei die erste und die zweite Platte vorzugsweise zum Äußeren bzw. zum Inneren des Schutzraums gerichtet sind.

7. Schutzraum nach einem der Ansprüche 1 bis 6, dadurch gekennzeichnet, daß die ersten Dämpfungsmittel in der Luftschicht (153) zwischen der inneren und äußeren Füllung untergebracht sind und eine Verbindung aus elastischem Kunststoff (191) umfassen; die vorzugsweise aus einem oder mehreren angebauten, vorzugsweise röhrenförmigen Kautschukbändern besteht.

8. Schutzraum nach einem der Ansprüche 1 bis 6, dadurch gekennzeichnet, daß die ersten Dämpfungsmittel, die in der Luftschicht (153) zwischen der inneren und der äußeren Füllung untergebracht sind, Ringe (545) sind, die an den Flächen der inneren und äußeren Füllung, welche die Luftschicht begrenzen, befestigt sind.

9. Schutzraum nach einem der Ansprüche 1 bis 6, dadurch gekennzeichnet, daß die ersten Dämpfungsmittel, die in der Luftschicht (153) zwischen der inneren und äußeren Füllung untergebracht sind, aus Schraubenfedern oder Spiralseilen gebildet sind, die an den Flächen der inneren und äußeren Füllung, welche die Luftschicht begrenzen, befestigt sind.

10. Schutzraum nach einem der Ansprüche 1 bis 6, dadurch gekennzeichnet, daß die ersten Dämpfungsmittel, die in der Luftschicht (153) zwischen der inneren und äußeren Füllung untergebracht sind, Schraubenfedern (49) sind, die sich senkrecht zur inneren und äußeren Füllung erstrecken.

11. Schutzraum nach einem der Ansprüche 1 bis 6, dadurch gekennzeichnet, daß die ersten Dämpfungsmittel, die in der Luftschicht (153) zwischen der inneren und äußeren Füllung untergebracht sind, Sätze von Belleville-Dichtungsringen (48) sind, aufgereiht um Wellen (481), die zur inneren und äußeren Füllung senkrecht sind.

12. Schutzraum nach einem der Ansprüche 1 bis 11, dadurch gekennzeichnet, daß die zweiten Dämpfungsmittel eine Verbindung aus elastischem Kunststoff (192) sind, wie etwa ein flaches Kautschukband.

13. Schutzraum nach Anspruch 12, dadurch gekennzeichnet, daß die zweiten Dämpfungsmittel (192) zwischen einer Fläche der äußeren Füllung (155) und einer demontierbaren Deckplatte (193) eingespannt sind, die vorzugsweise als T-Profil ausgebildet und an den Gerippeelementen (11, 14), welche die Wand (15) einrahmen, befestigbar ist, vorzugsweise mittels Dichtungen (147) und/oder elektrischen Verbindungen (146).

14. Schutzraum nach einem der Ansprüche 1 bis 13, dadurch gekennzeichnet, daß besagte Wand (20, 23, 25) und die Elemente (3), welche die Wand einrahmen, einen Flügel (2) einer Tür des Schutzraums bilden, mit einem aus den Pfosten und Querträgern des Gerippes gebildeten Rahmenwerk.

15. Schutzraum nach Anspruch 14, dadurch gekennzeichnet, daß zwei elastische Dichtungen (45, 46), vorzugsweise um den Flügel herum befestigt, einen Spalt zwischen Anschlag (322) und Falz der Tür verschließen, wenn diese geschlossen ist.

16. Schutzraum nach Anspruch 15, dadurch gekennzeichnet, daß die eine (45) der zwei Dichtungen einen T-Querschnitt besitzt, mit Schenkeln (452, 453), die vorzugsweise gegen die Ränder der Außenseiten des Flügels (2) bzw. des Rahmens (14) angelegt bzw. anlegbar sind, einem Stiel (451), der am Falz (31) des Flügels (2) befestigt ist, und einer gebogenen Lippe (454), die gegen den Anschlag (322) des Rahmens anliegt.

17. Schutzraum nach einem der Ansprüche 14 bis 16, dadurch gekennzeichnet, daß er Mittel für elektrischen Kontakt (324, 311) umfaßt, die zum Teil am Anschlag (322) der Tür und zum Teil am Falz (31) der Tür befestigt sind.

18. Schutzraum nach einem der Ansprüche 14 bis 16, dadurch gekennzeichnet, daß er eine innere Tür (2i) umfaßt, die hinter der vorgenannten sogenannten äußeren Tür (2i) angeordnet ist, wobei die innere Tür (2i) einen Flügel (21i, 22i, 24i), der einer inneren Füllung (150) der Wand (15) des Schutzraums entspricht, und einen Rahmen, aufweist, der von den Pfeilern und Querträgern (143i) des Gerippes gebildet wird.

19. Schutzraum nach Anspruch 18, dadurch gekennzeichnet, daß er Mittel für elektrischen Kontakt (324i, 311i) umfaßt, die zum Teil am Anschlag (322i) der inneren Tür und zum Teil am Falz (31i) der inneren Tür befestigt sind.

20. Schutzraum nach Anspruch 17 oder 19, dadurch gekennzeichnet, daß die Mittel für elektrischen Kontakt ein metallisches Widerlager (324; 324i), vorzugsweise aus Messing, das am Anschlag (322; 322i) befestigt ist, und ein metallisches Auflager (312, 312i), vorzugsweise aus Messing, das am Falz (31; 31i) befestigt ist und flexible Kontaktblättchen (311; 311i) trägt, die geeignet sind, mit dem Widerlager (31, 31i) in Kontakt zu kommen, wenn die Tür (2, 2i) geschlossen ist, umfassen.

21. Schutzraum nach Anspruch 20, dadurch gekennzeichnet, daß das Widerlager (324; 324i) und das Auflager mit Blättchen (312; 312i) mittels bimetallischen Stücken (325; 325i; 312; 312i), vorzugsweise aus Aluminium und Kupfer, am Anschlag (322; 322i) bzw. am Falz (31; 31i) befestigt sind.

## Claims

1. Shelter including walls (15) enframed by members (11, 14) of a metallic structure, at least a wall (15) comprising a panel (150) having at least one metal side (151; 152) connected electrically to structure members (11, 14) enframing the wall, characterized in that said panel is an internal panel (150) and said wall (15) further comprises an external armoring panel (155; 156, 157), an air space (153) between the internal and external panels, and first and second absorbing means (191, 192) for keeping the external panel floating between the internal panel and the structure members (11, 14).

2. Shelter according to claim 1, characterized in that the internal panel (150) comprises two metal sides (151, 152), preferably in aluminium, connected electrically in parallel to structure members (11, 14).

3. Shelter according to claim 1 or 2, characterized in that the internal panel (150) is sandwich type, and has a core (154) preferably in polyurethane foam.

4. Shelter according to claims 1 to 3, characterized in that the external panel (154) is in synthetic material preferably reinforced with fiberglass, carbon or likes or metallic components, such as an expanded metal sheet.

5. Shelter according to any one of claims 1 to 3, characterized in that the external panel consists of a first sheet of synthetic material (156), preferably laminated with layers of KEVLAR® type fibres, surrounded by a protective envelope preferably in PVC, and a second sheet (157), preferably honeycomb, in aluminium or in phenolic paper, the first and second sheets being preferably directed respectively to the outside and inside of the shelter.

6. Shelter according to claims 1 to 3, characterized in that the external panel, preferably when the wall (13) is a ceiling part of the shelter, consists of a first synthetic material sheet (136), preferably laminated with layers of KEVLAR type fibres surrounded by a protective envelope preferably in PVC, and of a second sheet (137) of sandwich panel type composed of a core preferably in polyurethane foam, having metal side preferably in aluminium, the first and second sheets being preferably directed respectively to the outside and the inside of the shelter.

7. Shelter according to claims 1 to 6, characterized in that the first absorbing means are located in the air space (153) between the internal and external panels and comprise a seal in flexible synthetic material (191), made preferably of one or several coupled strips of elastomeric material, preferably tubular.

8. Shelter according to any one of claims 1 to 6, characterized in that the first absorbing means located in the air space (153) between the internal and external panels are metal rings (445) secured to the sides of the internal and external panels delimiting the air space.

9. Shelter according to any one of claims 1 to 6, characterized in that the first absorbing means located in the air space (153) between the internal and external panels are constituted by springs or helicoidal cables secured to the sides of the internal and external panels delimiting the air space.

10. Shelter according to any one of claims 1 to 6, characterized in that the first absorbing means located in the air space (153) between the internal and external panels are coil springs (49) extending prependicularly to the internal and external panels.

11. Shelter according to any one of claims 1 to 6, characterized in that the first absorbing means located in the air space (153) between the internal and external panels are sets of Belleville washers (48) strung around pins (481) perpendicular to the internal and external panels.

12. Shelter according to any one of claims 1 to 11, characterized in that the second absorbing means are a seal in flexible synthetic material (192), such as flat strip in caoutchouc.

13. Shelter according to claim 12, characterized in that the second absorbing means (192) are clamped between an outer side of the external panel (155) and a detachable cover-plate (193), preferably of Tee-shape, securable to structure members (11, 14) enframing the wall (15), preferably via tight seals (147) and/or electrical joints (146).

14. Shelter according to any one of claims 1 to 13, characterized in that said wall (20, 23, 25) and the members enframing the wall constitute a leaf (2) of a shelter door having a frame formed by posts and cross-bars (14, 11) of the structure.

15. Shelter according to claim 14, characterized in that two flexible tight seals (45, 46), preferably secured to the leaf (2), obstruct an interstice between fillister (322) and back-fillister (31) of the door when the latter is closed.

16. Shelter according to claim 15, characterized in that one (45) of the two tight seals has a Tee cross-section having flanges (452, 453) preferably applied and applicable against edges of outer sides of the leaf (15) and the frame (14) respectively, a leg (451) secured to the back-fillister (31) of the leaf (2), and a bent lip (454) applied against the frame fillister (322).

17. Shelter according to any one of claims 14 to 16, characterized in that it comprises electrical contact means (324, 311) fastened partly to the door fillister (322) and partly to the door back-fillister (31).

18. Shelter according to any one of claims 14 to 16, characterized in that it comprises an inner door (2i) located behind the afore-cited door called as outer door (2e), the inner door (2i) having a leaf (21i, 22i, 24i) analogous to an internal panel (150) of the shelter wall (150) and having a frame formed by posts and cross-bars (143i) of the structure.

19. Shelter according to claim 18, characterized in that it comprises electrical contact means (324i, 311i) fastened partly to the inner door fillister (322i) and partly fastened to the inner door back-fillister (31i).

20. Shelter according to claim 17 or 19, characterized in that the electrical contact means include a metal stop (324; 324i) preferably in brass, fastened to the fillister (322; 322i), and a metal support (312, 312i), preferably in brass, fastened to the back-fillister (31; 31i) and supporting flexible contact strips (311, 311i) engageable into contact with the stop (31, 31i) when the door (2, 2i) is closed.

21. Shelter according to claim 20, characterized in that the stop (324; 324i) and the strip support (312, 312i) are respectively fastened to the fillister (322; 322i) and to the back-fillister (31; 31i) by bimetal parts (325; 325i; 312; 312i), preferably in aluminium and copper.

FIG.1

FIG. 2

FIG_3A

EP 0 233 427 B1

FIG. 3B

FIG_3C

# FIG.4A

EP 0 233 427 B1

FIG_4B